# EUROPEAN PATENT APPLICATION

(11) **EP 0 723 292 A2**
(43) Date of publication of application: **24.07.1996**
(21) Application number: 96100790.3
(22) Date of filing: 19.01.1996
(51) Int. Cl.: H01L 23/24, H01L 23/373

(54) **Semiconductor device**

(30) Priority: 19.01.1995 JP 6104/95
(71) Applicant: FUJI ELECTRIC CO. LTD., Kawasaki 210 (JP)
(72) Inventor: Nishiura, Masaharu, c/o Fuji Electric Co., Ltd., Kawasaki 210 (JP); Morozumi, Akira, c/o Fuji Electric Co., Ltd., Kawasaki 210 (JP); Shimizu, Tomio, c/o Fuji Electric Co., Ltd., Kawasaki 210 (JP); Yamada, Katsumi, c/o Fuji Electric Co., Ltd., Kawasaki 210 (JP); Saito, Shigemasa, c/o Fuji Electric Co., Ltd., Kawasaki 210 (JP)
(74) Representative: Hoffmann, Eckart, Dipl.-Ing.

(57) **Abstract**

Disclosed is a semiconductor device having a semiconductor power module mounted on a circuit board (2) comprising an insulating ceramic plate. The ceramic plate 2a is fabricated by sintering at high temperature an alumina powder compact containing zirconia and either one of the additives yttria, calcia, magnesia, and ceria. The flexural strength and the thermal conductivity of this ceramic plate of the invention are remarkably improved compared to one made from only alumina. The thickness of the ceramic plate can, thus, be reduced. The circuit board quickly radiates heat generated in the semiconductor device.

## Description

The present invention relates to a semiconductor device, a so-called "power module", which has a case housing a circuit board on that one or more semiconductor chips are mounted, and which is used in, e.g., converters and inverters. More specifically, the present invention relates to the circuit board of the semiconductor device, such as a CBC substrate (CBC = Ceramic Bonding Copper) consisting of a ceramic core plate and foil-shaped copper plates directly bonded to the ceramic core plate, which is used as such circuit board.

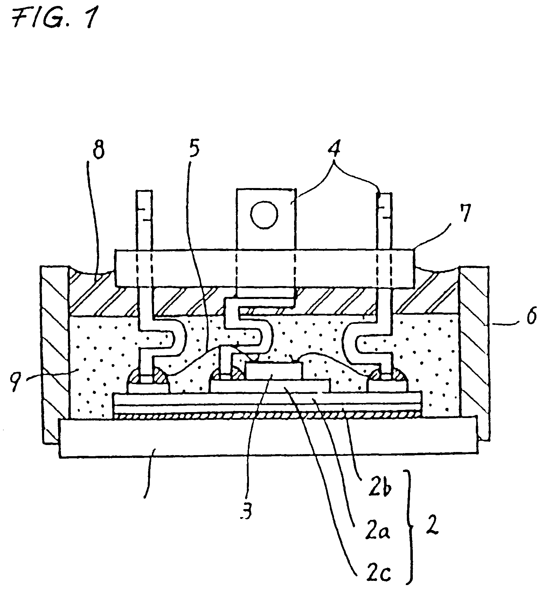

The background of the invention will be explained with reference to Fig. 1 showing an example of such a power module having: a laminate substrate (CBC substrate) 2 soldered on a metal radiator base 1 which forms the bottom of a resin case 6; a semiconductor chip 3 mounted on the CBC substrate 2; lead-out terminals 4 of a lead frame having curved or bent tips which are soldered to a circuit pattern patterned in a front copper plate 2c of the CBC substrate 2; a terminal block 7 that fixes the lead-out terminals 4; bonding wires 5 which connect the semiconductor chip 3 and the circuit pattern to that the curved tips of the lead-out terminals 4 are fixed; gel resin 9 that fills the inner space of the resin case 6 above the metal radiator base 1; and a sealant resin 8 that closes the resin case 6.

As shown in the figure, the CBC substrate 2 has a laminate structure and consists of a ceramic plate (insulating core plate) 2a, a thin foil-shaped front copper plate 2c and a thin foil-shaped back copper plate 2b. The ceramic plate 2a is made, for example of alumina (Al₂O₃), aluminum nitride (AIN), etc. The front and back copper plates 2c and 2b are directly bonded to the ceramic plate 2a, for example, by the direct bonding copper method (the method of bonding copper by using a Cu-O eutectic liquid phase yielded by a reaction of copper and a trace amount of oxygen). A circuit pattern (thick film circuit pattern) is formed from the copper plate 2c.

When the CBC substrate 2 is used as a thick film circuit board on that a semiconductor chip 3 is mounted, the following problems are caused.

Since the semiconductor chip 3 such as a power transistor module generates much heat when a current flows through the semiconductor chip 3, and since the generated heat is conducted to the metal radiator base 1 via the CBC substrate 2 to be radiated to the outside of the case, the thermal conductivity of the CBC substrate 2 is an important factor that determines the current capacity of the semiconductor device.

However, because of its laminate structure the thermal conductivity of the CBC substrate 2 is relatively low. The thermal conductivity of alumina and aluminum nitride used as the material of the ceramic plate 2a are 21 W/m·K and 180 W/m·K, respectively. Though aluminum nitride is superior to alumina in thermal conductivity, aluminum nitride is twice or more as expensive as alumina.

To improve the heat radiation of the semiconductor devices, the metal radiator plate 1 is sometimes fixed to a heat sink with a bolt or bolts. Then, bending stress will be exerted to the metal radiator plate 1 if the heat sink warps, and the metal radiator plate 1 and the CBC substrate 2 soldered to the metal radiator plate 1 are sometimes deflected by the bending stress. As a result, a crack or cleavage is caused in the ceramics, the flexural strength and the deflection tolerance thereof being low.

The flexural strength is around 300 MPa for aluminum nitride and around 400 MPa for alumina, and the deflection tolerance is around 0.2 mm for aluminum nitride and around 0.3 mm for alumina. Mechanically, aluminum nitride is weaker than alumina. Though the deflection of the heat sink may be assumed to be only around 100 µm on the average, various counter measures should be taken for preventing cracks from occurring considering variations of the deflection among individual heat sinks.

As one counter measure for preventing such cracks, it is possible to make the deflection tolerance of the CBC substrate sufficiently greater than the maximum expected deflection caused in the semiconductor device by dividing the CBC substrate into a plurality of individual substrates. However, the interspaces between the individual CBC substrates fixed on the metal base 1 impede the device integration, enlarge the semiconductor device, and increase the number of parts and components as well as cumbersome internal wiring work between the CBC substrates. Therefore, using a plurality of small CBC substrates instead of a single larger one is not an effective solution.

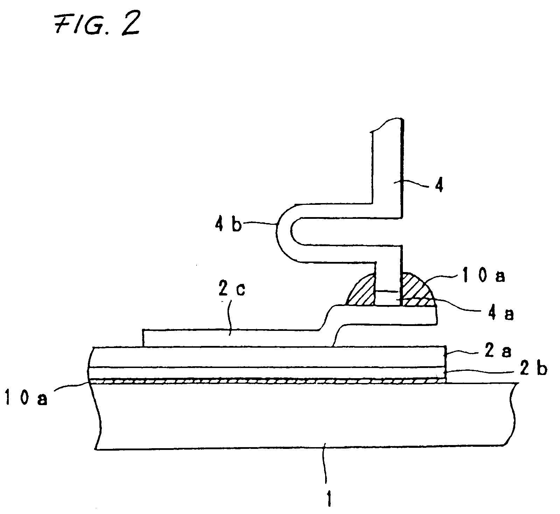

As another counter measure for preventing cracks, the internal part of the lead-out terminals 4 may be provided with a U shaped bend 4b near the end or tip 4a connected to the circuit pattern as shown in Figs. 1 and 2 to provide for elasticity. Additionally, the peripheral part of the copper plate 2c forming the circuit pattern may be made floating a little bit above the ceramic plate 2a. Since any stress caused in the ceramic plate 2a may be relaxed by the combination of the bend 4b and the floating part of the copper plate 2c, it becomes possible to prevent cracks etc. from occurring in the CBC substrate. However, since a pressing process is necessary for every terminal to form the bend 4b, this counter measure is not suited to a batch assembly wherein the lead frame, having many lead-out terminals 4 connected with one another by a tie bar, is fixed to the terminal block, then the inner lead tips are soldered, and finally, the tie bar is cut. Furthermore, an increase of manufacturing cost for the CBC substrate is caused, since etching and cleaning processes are necessary to make the peripheral part of the copper plate 2c floating.

One might think of reducing the thermal resistance in order to improve the heat radiation by reducing the thickness of the ceramic plate made of cheap alumina. However, when the thickness of the ceramic plate made of alumina is reduced to become as thin as, for example, 0.3 mm, the substantial strength (resistance against impact) of the plate lowers. As the substantial strength (resistance against impact) of the ceramic plate lowers, defects are caused more often, during the bonding of the semiconductor (silicon) chip 3 and the copper plate 2c to one another. These defects are caused by the thermal stress caused due to the differences in the thermal expansion coefficients of the constituent materials of the CBC substrate. The thermal expansion coefficients of the materials involved are:

| | |
|---|---|
| Silicon (semiconductor chip): | 4.0x10⁻⁶/°C |
| Alumina: | 7.5x10⁻⁶/°C |
| Copper: | 18.0x10⁻⁶/°C |

In view of the foregoing, it is an object of the invention to provide a semiconductor device using a CBC substrate with a ceramic core plate which mainly contains cheap alumina, and which has a relatively small thickness and yet an improved mechanical strength, especially fracture toughness (toughness against deflection) without requiring any special structure for stress relaxation.

This object is achieved with a semiconductor device as claimed in claim 1. Preferred embodiments are subject-matter of the dependent claims.

The mechanical strength, especially the flexural strength, of the insulating ceramic plate according to the present invention, which contains alumina as the main component, zirconia and at least one additive selected from the group consisting of yttria, calcia, magnesia, and ceria, is greatly improved as compared with the conventional undoped alumina ceramic plate. The thermal conductivity of the ceramic plate is further improved without deteriorating the mechanical strength, especially the deflection tolerance, by setting the added amount of zirconia at between 2.5 and 17.5 % by weight (wt.-%). This allows to reduce the thickness of the ceramic plate resulting in a CBC substrate contributing to heat being quickly radiated from the semiconductor devices.

The additives yttria, calcia, magnesia and ceria lower the sintering temperature of the ceramic plate, and improve the toughness of the zirconia grains. These effects may be obtained either by adding yttria, calcia, magnesia and/or ceria, or by employing zirconia stabilized or partially stabilized with one or more of these additives.

Since the ceramic plate of the invention is strong enough it may be made larger (larger area) than was possible in the prior art. The larger substrate area further facilitates higher device integration. Since the U shaped bends of the lead-out terminals for stress relaxation are no longer necessary, the thickness of the semiconductor device can be reduced. Since, furthermore, the periphery of the copper plate need no longer be floating, the manufacturing steps and cost can be reduced.

Now the present invention will be explained hereinafter with reference to the drawings which illustrate preferred embodiments of the invention.
- Fig. 1: is a cross section of a conventional power transistor module;
- Fig. 2: is an enlarged cross section showing the connection between the CBC substrate and a lead-out terminal in the power transistor module of Fig. 1;
- Fig. 3(a): is a top plan view of an embodiment of a semiconductor device according to the present invention;
- Fig. 3(b): is a cross section along line A-A' of Fig. 3(a);
- Fig. 4(a): is a graph showing the relation between the thermal conductivity of the ceramic plate and the added amount of zirconia;
- Fig. 4(b): is a graph showing the relation between the flexural strength and the added amount of zirconia of the ceramic plate and the CBC substrate using it;
- Fig. 5(a): is a graph showing the relation between the thermal conductivity and the added amount of yttria of a ceramic plate containing 5 wt.% of zirconia;
- Fig. 5(b): is a graph showing the relation between the flexural strength and the added amount of yttria of a ceramic plate containing 5 wt.% of zirconia, and the CBC substrate using it;
- Fig. 6: is a graph showing the relation between the flexural strength and the deflection for three different ceramic plates with the plate thickness as a parameter;
- Fig. 7: is a graph showing the relation between the flexural strength and the deflection for three different CBC substrates with the plate thickness of the CBC substrates as a parameter;
- Fig. 8(a): is a graph showing the relation between the thermal conductivity and the added amount of zirconia of an alumina ceramic plate containing 0.75 wt.-% of magnesia;
- Fig. 8(b): is a graph showing the relation between the flexural strength and the added amount of zirconia of an alumina ceramic plate containing 0.75 wt.-% of magnesia and the CBC substrate using the magnesia doped ceramic plate;
- Fig. 9(a): is a graph showing the relation between the thermal conductivity and the added amount of magnesia of an alumina ceramic plate containing 5 wt.-% of zirconia;
- Fig. 9(b): is a graph showing the relation between the flexural strength and the added amount of magnesia of an alumina ceramic plate containing 5 wt.-% of zirconia and of a CBC substrate using the magnesia doped ceramic plate;
- Fig. 10(a): is a graph showing the relation between the thermal conductivity and the added amount of yttria and calcia of an alumina ceramic plate whose zirconia content is 5 wt.-%;
- Fig. 10(b): is a graph showing the relation between the flexural strength and the added amount of yttria and calcia of an alumina ceramic plate containing 5 wt.-% of zirconia and of a CBC substrate using the yttria and calcia doped ceramic plate;
- Fig. 11(a): is a graph showing the relation between the thermal conductivity and the added amount of magnesia and yttria of the alumina ceramic plate; and
- Fig. 11(b): is a graph showing the relation between the flexural strength and the added amount of magnesia and yttria of the alumina ceramic plate and the CBC substrate using the magnesia and yttria doped ceramic plate.

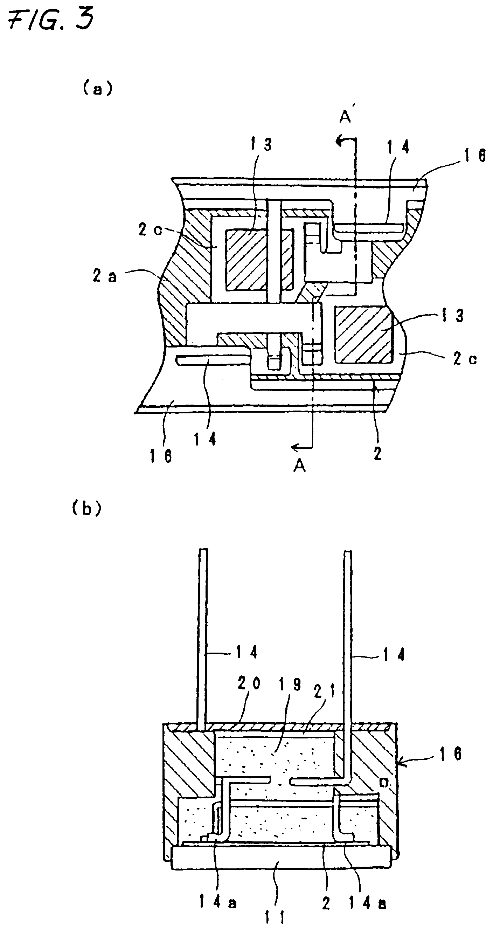

Fig. 3(a) is a top plan view of an embodiment of a semiconductor device according to the present invention. Fig. 3(b) is a cross section along line A-A' of Fig. 3(a). The illustrated semiconductor device is a semiconductor module called "power module" or "intelligent power module". The semiconductor device of Figs. 3(a) and 3(b) has an insulating resin case frame 16 having a lead frame; a metal radiator base 11 bonded to a first side of the case frame 16 so as to close a first opening of the case frame 16; a CBC substrate 2 soldered to the inner surface of the metal radiator base 11 and mounting thereon one or more semiconductor chips 13 (two being visible in Fig. 3a); lead-out terminals (lead frame) 14, with the inner lead tips 14a thereof being soldered to a foil-shaped copper plate 2c of the CBC substrate 2; gel resin (silicone resin) sealant 19 in that the CBC substrate 2 and the lead-out terminals 14 are immersed; and a cover plate 20 made of insulating resin, that is bonded with adhesive to a second side of the case frame 16 so as to close a second opening of the case frame 16. A space 21 is left between the gel resin sealant 19 and the cover plate 20. The CBC substrate 2 has the same basic structure as that described with reference to Fig. 1, i.e., it consists of a ceramic plate (insulating core plate) 2a, a thin foil-shaped front copper plate 2c and a thin foil-shaped back copper plate 2b (not shown in Fig. 3). The front and back copper plates are directly bonded to the ceramic plate 2a, for example, by the direct bonding copper method mentioned above. A circuit pattern (thick film circuit pattern) is formed from the copper plate 2c. In contrast to the example illustrated in Fig. 2, the peripheral part of the copper plate 2c is not floated in this embodiment. The elastic bending parts (4b in Fig. 2) of the lead-out terminals and the floated peripheral part of the copper plate are not necessary in this embodiment because of the improved fracture toughness of the ceramic core plate 2a as will be explained below.

### Ceramic Core Plate and CBC Substrate

The ceramic plate 2a was prepared in the following way: Alumina (Al₂O₃), to that zirconia (ZrO₂) and yttria (Y₂O₃) were added, was mixed and pulverized to a particle diameter of 0.5 to 3 µm. Then, the pulverized oxide mixture was mixed for 20 hrs with 8 wt.-% of polyvinyl butyral as a binder, 50 wt.-% of mixed solvent consisting of toluene and xylene, and 2 wt.-% of dioctyl phthalate (DOP) as a plasticizer. Then, a green sheet was formed from the mixture by the doctor blade method. Then, the green sheet was die-cut in a predetermined shape in a press. Finally, the die-cut specimens were sintered at 1550 to 1650 °C and sintered ceramic plates 0.2 to 0.7 mm in thickness were obtained.

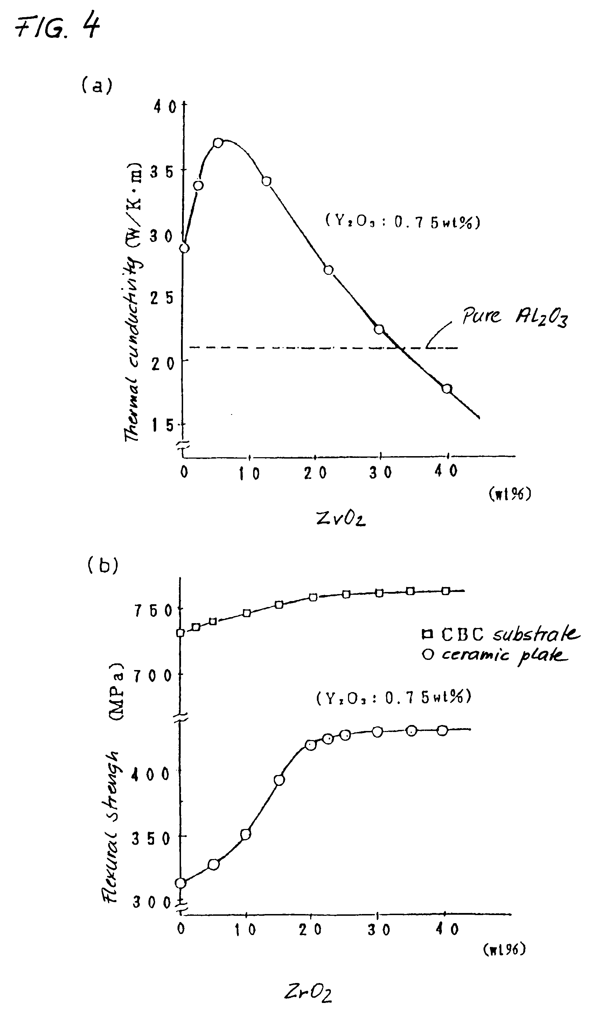

Fig. 4(a) is a graph relating the thermal conductivity of the ceramic plate with the added amount of zirconia. Fig. 4(b) is a graph relating the flexural strength of the ceramic plate and that of the CBC substrate, with the added amount of zirconia. The test specimens were 5 mm in width, 60 mm in length and 0.5 mm in thickness. Yttria was added as much as 0.75 wt.-% as a partial stabilizer. Referring now to Fig. 4(a), the thermal conductivity increases with a decreasing amount of zirconia, and exhibits higher values than the thermal conductivity of undoped alumina (represented by a broken line) between 0 and 30 wt.-% zirconia. If the added amount of zirconia was in the range of from 2.5 to 17 wt.-%, a thermal conductivity of 30 W/m·K, higher than the highest value reported for α-alumina, has been obtained. This very high thermal conductivity may be attributed to the added yttria. Fig. 4(b) shows the relation between the flexural strength (four-points bending) and the added amount of zirconia for both, the ceramic plate alone (indicated by circles) and the CBC substrate (indicated by squares) formed by bonding copper plates on the front and back surfaces of the ceramic plate. The flexural strength of the ceramic plate increases with an increasing amount of zirconia, and saturates beyond 25 wt.-% zirconia. The CBC substrate exhibits a flexural strength about twice as high as that of the ceramic plate, since the CBC substrate has a sandwich structure that sandwiches the ceramic plate between the tough copper plates. The decrease of the flexural strength of the CBC substrate with a deceasing amount of yttria is less remarkable than with the ceramic plate alone. The effects described above may be attributed to the large amount (0.75 wt.-%) of added yttria. Usually, impurity yttria of less than 0.01 wt.-% is inevitable in usual sintering of ceramics.

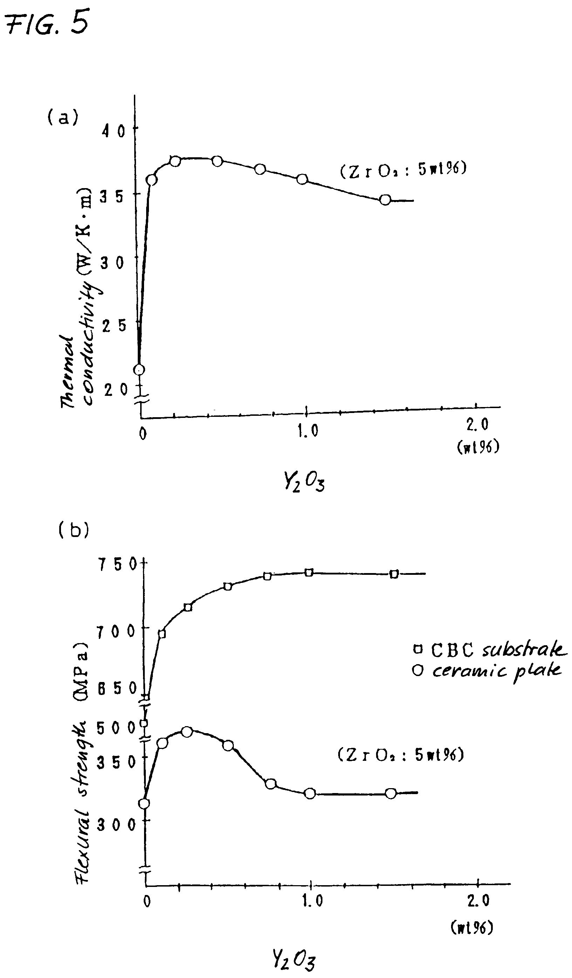

Fig. 5(a) is a graph relating the thermal conductivity of the ceramic plate having a fixed zirconia content of 5 wt.-%, with the added amount of yttria. The thermal conductivity shows a maximum between 0.2 wt.-% and 0.6 wt.-% of yttria. When no yttria (0 wt.-% ) is added, the thermal conductivity is near to that of the usual alumina (about 22 W/K·m) as shown in Fig. 4(a).

Fig. 5(b) is a graph relating the flexural strength of the ceramic plate including 5 wt.% of zirconia and that of the CBC substrate using it, with the added amount of yttria. The flexural strength of the ceramic plate shows a maximum at about 0.2 wt.-% yttria, decreases gradually when the amount of yttria increases beyond 0.2 wt.% and decreases sharply when the amount of yttria becomes less than 0.2 wt.%. The flexural strength of the CBC substrate lowers gradually when the added amount of yttria decreases below about 1 wt.%, and then lowers sharply towards the flexural strength at no yttria addition (0 wt.-%). Thus, the added yttria obviously contributes to the improvement of the properties of the ceramic plate. However, as the added yttria exceeds 2 wt.-%, the flexural strength exhibits large variations. Therefore, the optimum amount of yttria is from 0.1 to 2 wt.-%.

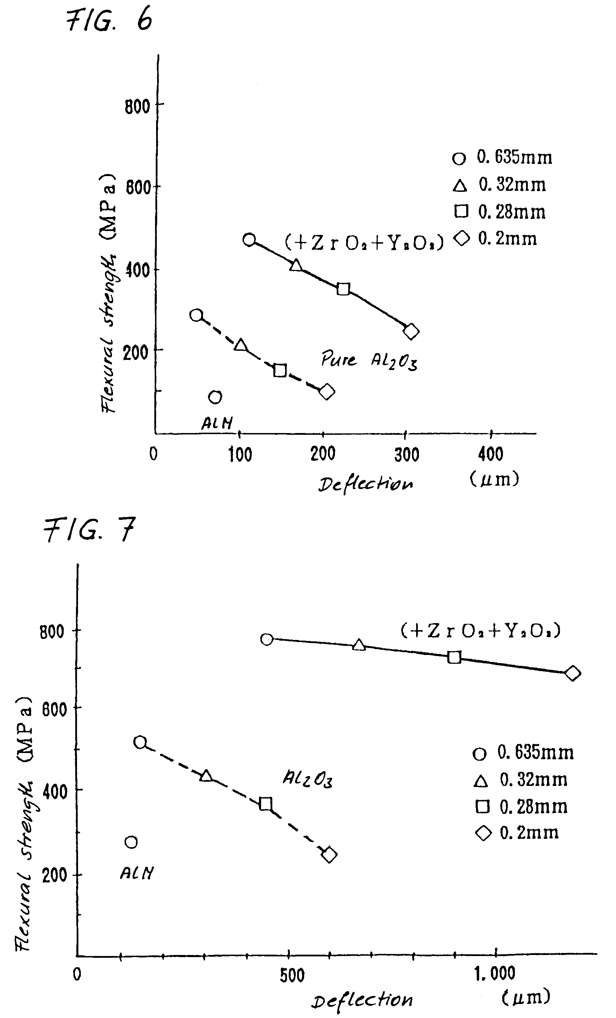

The flexural strength and the deflection that causes cracking depend greatly on the thickness of the ceramic plate. Fig. 6 is a graph showing the change in the relation between the flexural strength and the deflection with the thickness of a ceramic plate containing 22.5 wt.-% of zirconia and 0.75 wt.-% of yttria. Fig. 6 also shows the relations between the flexural strength and the deflection of the undoped alumina ceramic plate and the aluminum nitride ceramic plate. The alumina ceramic plate containing 22.5 wt.-% of zirconia and 0.75 wt.-% of yttria exhibits a higher flexural strength than the undoped alumina ceramic plate and the aluminum nitride ceramic plate, enough toughness against deflection (fracture toughness), and excellent resistance against impact.

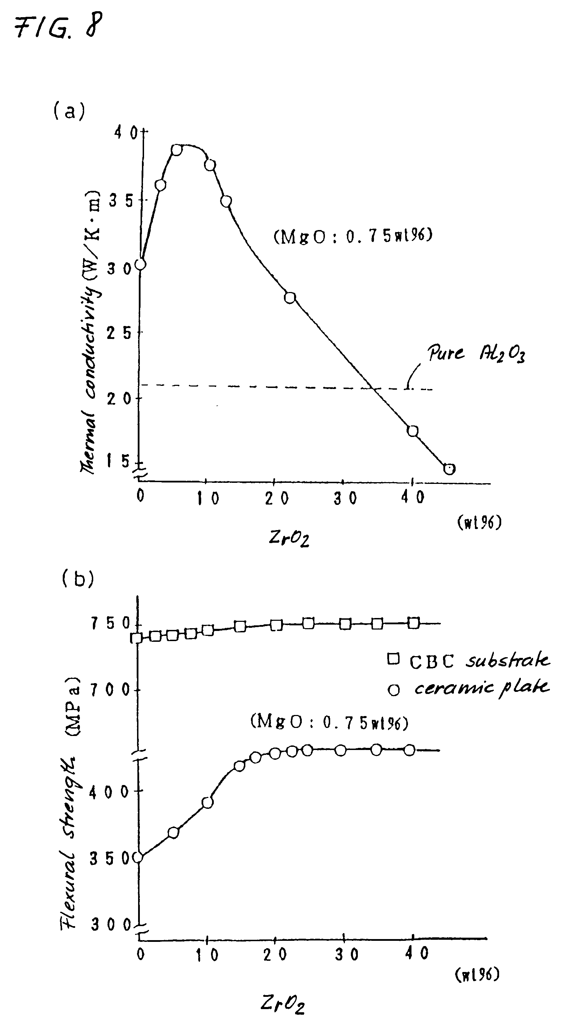

Fig. 7 is a graph showing the dependence of the relation between the flexural strength and the deflection on the plate thickness of the CBC substrates which have either one of the ceramic plates mentioned above with respect to Fig. 6. Though the flexural strength and the deflection of the CBC substrate compared to those of the corresponding ceramic plate are improved in each case, the improvement in the case of the CBC substrate in accordance with the invention, i.e., that having the ceramic plate made of alumina containing 22.5 wt.-% of zirconia and 0.75 wt.-% of yttria is higher than that of the others.

The greatly improved flexural strength of the CBC substrate exhibits the following effects. In the semiconductor device in which a CBC substrate 2 of the invention is mounted on the metal radiator base 11, the major face of the metal radiator base 11 inevitably warps, and the warp sometimes differs greatly from product to product. Though initial stress is exerted on the CBC substrate as the metal radiator base 11 warps, no crack is caused in the CBC substrate 2 of the invention, since the CBC substrate 2 exhibits high flexural strength and large deflection tolerance. Since the improved flexural strength and deflection tolerance allow to reduce the thickness of the CBC substrate that originally exhibits high thermal conductivity, the thermal conduction of the CBC substrate is further improved.

Since the composition of the ceramic plate according to the present invention is based on alumina, the apparatus and method used in the prior art need not be changed substantially for manufacturing the alumina ceramic plate of the invention. And, the alumina ceramic plate of the invention is manufactured at lower cost than that of ceramic plate made mainly of aluminum nitride.

The addition of magnesia (MgO), calcia (CaO), and ceria (CeO₂) instead of yttria was investigated. Calcia, and ceria have been found to exhibit almost the same effect as that of yttria. As will be explained below, the properties of the alumina ceramic plate have been found to be improved by the addition of magnesia even a little bit more than by the addition of yttria.

Fig. 8(a) is a graph showing the relation between the thermal conductivity and the added amount of zirconia in the alumina ceramic plate containing 0.75 wt.-% of magnesia. As shown in Fig. 8(a), the thermal conductivity of the magnesia doped ceramic plate is improved by about 8 % compared to that of the yttria doped ceramic plate (Fig. 4(a)). Fig. 8(b) is a graph showing the relation between the flexural strength and the added amount of zirconia in the alumina ceramic plate containing 0.75 wt.-% of magnesia and the CBC substrate that has the magnesia doped ceramic plate. As shown in Fig. 8(b), the flexural strength of the ceramic plate including the small amount of magnesia is better than that of the ceramic plate including the same amount of yttria instead (Fig. 4(b)), and as a result, the flexural strength of the CBC substrate is also improved to some extent.

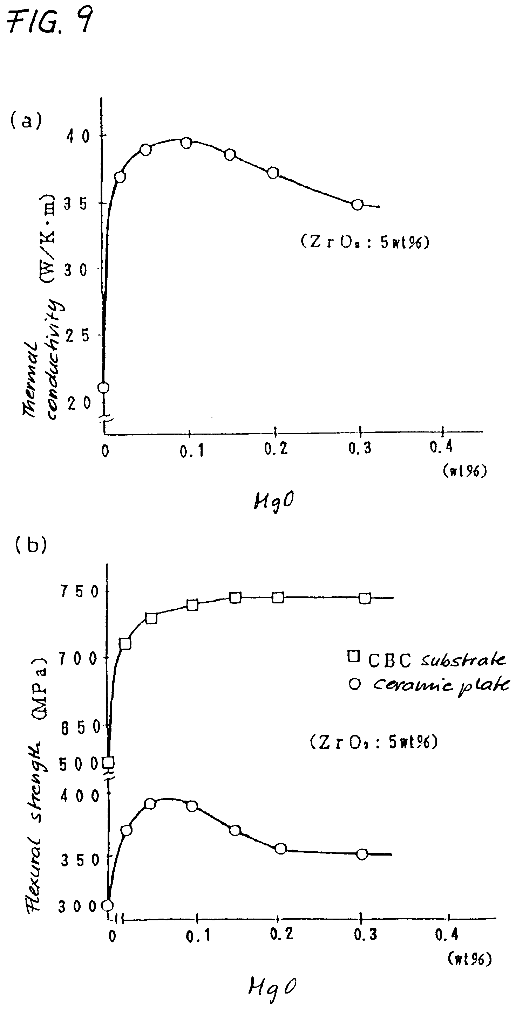

Fig. 9(a) is a graph showing the relation between the thermal conductivity and the added amount of magnesia in the alumina ceramic plate containing 5 wt.-% of zirconia. Fig. 9(b) is a graph showing the relation between the flexural strength and the added amount of magnesia in the alumina ceramic plate containing 5 wt.-% of zirconia and the CBC substrate using this magnesia doped ceramic plate.The thermal conductivity and the flexural strength shown respectively in Figs. 9(a) and 9(b) are almost the same as those shown in Figs. 5(a) and 5(b) for the yttria doped ceramic plate and the CBC substrate having the yttria doped ceramic plate. However, when the amount of magnesia exceeds 0.4 wt.-%, large variations are caused in the shrinkage percentage and mechanical strength of the ceramic plate. Therefore, the optimum amount of magnesia is 0.01 to 0.4 wt.-%.

The addition of calcia and ceria showed almost similar effects. The optimum amount is 0.02 to 0.5 wt.-% for calcia, and 0.05 to 2 wt.-% for ceria.

The thermal conductivity and the flexural strength were also measured for ceramic plates that contained at least two kinds of additives selected from the group consisting of yttria, magnesia, calcia and ceria. The effects of the two additives will be explained by referring to the total amount of two kinds of additives in mol %.

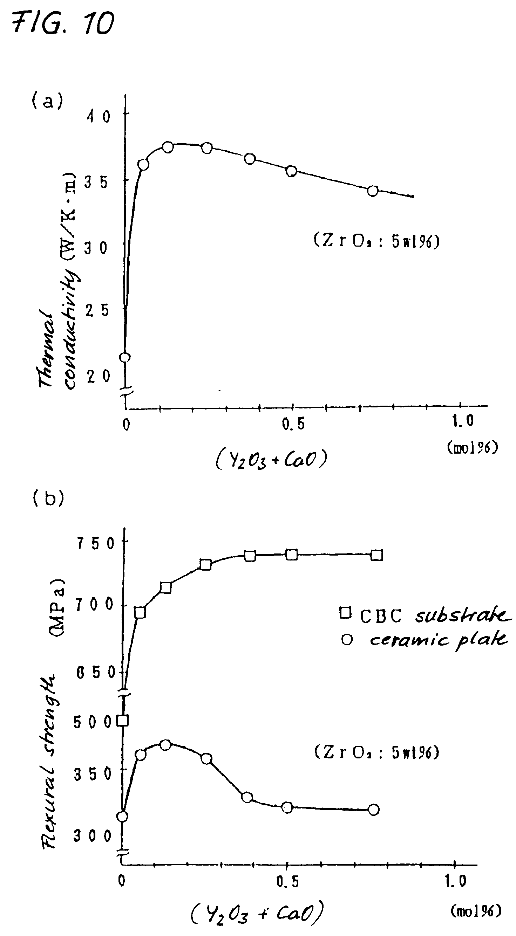

Fig. 10(a) is a graph showing the relation between the thermal conductivity and the added amount of yttria and calcia in the alumina ceramic plate containing 5 wt.% zirconia. Fig. 10(b) is a graph showing the relation between the flexural strength and the added amount of yttria and calcia in the alumina ceramic plate containing 5 wt.-% of zirconia, and the CBC substrate that has the yttria and calcia doped ceramic plate. When the added amount of zirconia is 5 wt.-%, the thermal conductivity shows a maximum at the total added amount of yttria and calcia of 0.1 to 0.3 mol %. The flexural strength shows a maximum at the total added amount of yttria and calcia of 0.1 to 0.2 mol %.

Properties similar to those of the above described combination of yttria and calcia are obtained by the combination of yttria and ceria, the combination of calcia and ceria, and the combination of yttria, ceria and calcia. However, when the total amount of the combined additives exceeds 1 mol %, large variations are caused in the shrinkage percentage and mechanical strength of the ceramic plate. Therefore, the optimum total amount of the combined additives is 0.05 to 1 mol %.

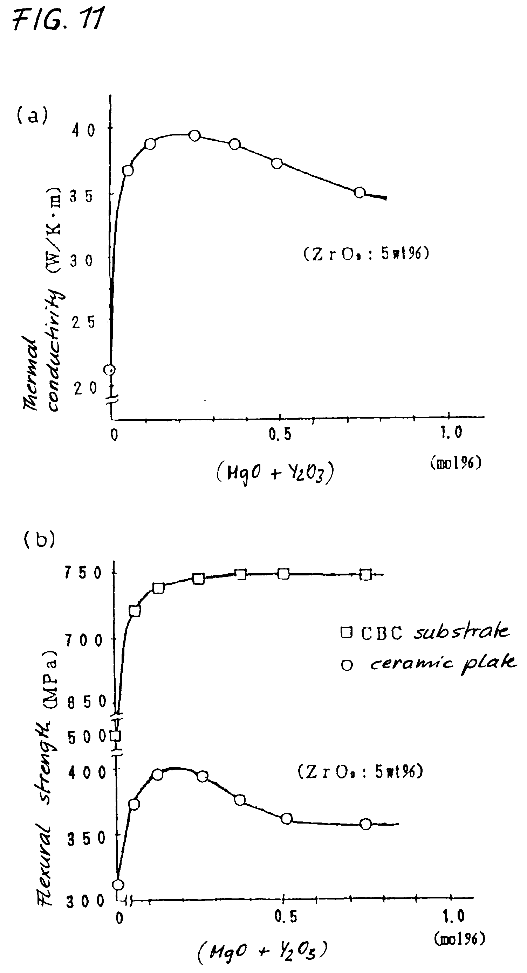

Fig. 11(a) is a graph showing the relation between the thermal conductivity and the added amount of magnesia and yttria in the alumina ceramic plate, and Fig. 11(b) is a graph showing the relation between the flexural strength and the added amount of magnesia and yttria in the alumina ceramic plate and the CBC substrate that has the magnesia and yttria doped ceramic plate. The zirconia content was 5 wt.-%. The alumina ceramic plate and the CBC substrate of Fig. 11(b) exhibit a flexural strength improved to some extent as compared with the flexural strength of the alumina ceramic plate and the CBC substrate of Fig. 9(b) containing magnesia as a single additive. Effects similar to those of the ceramic plate containing magnesia and yttria are obtained by an alumina ceramic plate containing the combined additives of magnesia and calcia; magnesia and ceria; magnesia, yttria and calcia; magnesia, calcia and ceria; or magnesia, yttria, calcia and ceria. However, when the total amount of the combined additives exceeds 1 mol %, large variations are caused in the shrinkage percentage and mechanical strength of the ceramic plate. Therefore, the optimum total amount for these combined additives is 0.05 to 1 mol %.

The same tendencies as those shown in Figs. 6 and 7 on the ceramic plate containing only the yttria additive were observed on the ceramic plate containing a single additive of magnesia, calcia or ceria, or at least two kinds of oxides selected from the group consisting of magnesia, calcia, ceria and yttria.

The semiconductor device of Figs. 3(a) and 3(b) including the present ceramic core plate of 0.2 mm in thickness in the CBC substrate was assembled. In addition, a comparative semiconductor device including an aluminum nitride ceramic core plate of 0.63 mm in thickness was assembled. A mechanical deformation tolerance test was conducted and temperature rise by a discontinuous current flow was measured on these experimental devices.

In the deformation tolerance test, the metal radiator plate 1 was forced to deform by an external force, and deformation that results in deteriorated insulation of the ceramic core plate 2a and strength of the ceramic core plate 2a was investigated. The ceramic core plate 2a of the invention is 2.5 times as strong as the aluminum nitride ceramic core plate. Furthermore, the ceramic core plate 2a of the invention may be deformed 4 times as large as the aluminum nitride ceramic core plate before deteriorated insulation thereof is caused. Thus, the ceramic core plate of the invention is remarkably improved in the strength against the insulation deterioration. By adding an appropriate amount of zirconia and an additive or additives (magnesia, calcia, ceria, yttria) to alumina (Al₂O₃ + ZrO₂ + additive(s)) or by adding an appropriate amount of zirconia totally or partially stabilized with one or more of the additives (Al₂O₃ + (stabilized)-ZrO₂), the ceramic core plate 2a can be substantially reduced to one third in the thickness thereof.

An equivalent or lower semiconductor junction temperature rise ΔT was observed at the same collector loss of the semiconductor chip mounted on the CBC substrate that used the ceramic core plate of the invention as compared with the semiconductor chip mounted on the CBC substrate that used the conventional aluminum nitride ceramic core plate. Thus, the current carrying capacity, several times as high as that for the usual alumina plate, was observed for the ceramic core plate of the invention.

As described above, the ceramic core plate employed according to the invention is superior in the mechanical properties to the conventional alumina or aluminum nitride core plate. The ceramic core plate of the invention facilitates reducing the thickness of insulating substrates, and therefore, the ceramic core plate of the invention is quite suitable for providing insulating substrates, which facilitate quick heat radiation, for the semiconductor devices.

The semiconductor device shown in Figs. 3(a) and 3(b), that uses the CBC substrate of the invention is particularly advantageous because of the improved strength of the ceramic core plate, the improved adhesion between the ceramic core plate and the copper plates (due to the avoidance of floating portions), the increased soldering area of leads on the copper plate (caused by a continuous large copper plate area resulting from the improved strength of the ceramic plate), and absorption of the thermal expansion of the gel resin sealant 19 by the space 21 left on thereon which contributes to the improvement in withstand capability against or avoidance of thermal stress.

The conventional floated peripheral structure of the copper plate is avoided by virtue of the improved strength of the ceramic core plate of the invention. Therefore, etching, cleaning after the etching, etc. are not necessary, and etching residuals which may exude through the gap between the ceramic plate and the floating copper plate are not formed.

Since the bending parts (U shaped bends) of the inner leads for stress relaxation are not required, it is now possible to integrate a plurality of leads into a unitary lead frame, by which the workability of the semiconductor device assembly is further improved.

Though the thickness of the ceramic plate has been mentioned to be 0.5 mm and 0.2 mm as an example in the above described embodiment, a ceramic sheet of 0.05 to 5 mm in thickness can be formed by the doctor blade method, the extrusion-rolling method, calender method, etc. By adding a binder such as polyvinyl alcohol etc. to the raw material powder, wet-blending the raw materials, dry-granulating the wet blend by a spray dryer, and forming sheet compacts in a press, ceramic plates having quite uneven sectional profiles may be formed.

By extruding the wet blend, ceramic plates, having an even cross section in the extrusion direction and uneven cross sections perpendicular to the extrusion direction may be obtained. By the injection molding, variously shaped ceramic plates having uneven cross sections also in the extrusion direction may be obtained. By utilizing recess portions formed on these uneven ceramic plates to position the copper plate in advance, the copper and ceramic plates may hardly be displaced from one another during the bonding of these plates.

In the above described embodiments, the direct bonding method has been mentioned as an example for bonding the ceramic plate and the copper plate with one another. The ceramic plate and the copper plate may be chemically bonded with one another by such bonding methods as the active metal method, the metalizing method, etc. by adding Ti to a silver solder.

Since the junction temperature rise is low on the ceramic core plate of the invention, the substrate may be designed easily as one that hardly warps.

## Claims

1. A semiconductor device comprising:
a case frame (16) made of insulating resin;
a lead frame (14) comprising inner lead portions inside of the case frame and outside lead portions outside of the case frame;
a metal radiator base (11) closing a first opening of said case frame;
a substrate (2) comprising a ceramic plate (2a) and a foil-shaped electrically conductive plate (2b, 2c) on at least one side of the ceramic plate, the substrate being fixed on the inner face of the metal radiator base (11);
a semiconductor chip (13) mounted on the substrate and connected to the tips (14a) of said inner lead portions;
a cover plate (20) made of insulating resin and closing a second opening of said case frame; and
a gel resin sealant (19) filling the inner space of said case frame;
**characterized in that** said ceramic plate (2a) contains alumina as the main component, zirconia, and at least one additive selected from the group consisting of yttria, calcia, magnesia, and ceria.

2. The semiconductor device of claim 1, wherein said ceramic plate contains from more than 70 to less than 100 wt.-% of alumina, no more than 30 wt.-% of zirconia, and from 0.02 to 2 wt.-% of said at least one additive.

3. The semiconductor device of claim 2, wherein said at least one additive is any one of
yttria in an amount of from 0.1 to 2 wt.-%,
calcia in an amount of from 0.02 to 0.5 wt.-%,
magnesia in an amount of from 0.02 to 0.4 wt.-%, and
ceria in an amount of from 0.02 to 0.5 wt.-%.

4. The semiconductor device of claim 2, wherein said at least one additive includes at least two of said additives, the total content thereof being from 0.05 to 1.0 mol %.

5. The semiconductor device of either one of claims 1 through 4, wherein the content of alumina is from 82 to 97 wt.-%, and the content of zirconia is from 2.5 to 17.5 wt.-%.

6. The semiconductor device of either one of claims 1 through 5, wherein the grain diameter of the powder raw materials of said ceramic plate is from 0.5 to 3 µm.

7. The semiconductor device of either one of claims 1 through 6, wherein foil-shaped copper plates (2b, 2c) are bonded to both major faces of said ceramic insulation plate (2a).
